Europäisches Patentamt

European Patent Office

Office européen des brevets

(11) Publication number: **0 426 496 A2**

# EUROPEAN PATENT APPLICATION

(21) Application number: 90312042.6

(22) Date of filing: 02.11.90

(51) Int. Cl.⁵: **H05K 3/46**, H05K 3/00, H01L 21/90, H01L 21/461

(30) Priority: 03.11.89 US 431554

(43) Date of publication of application:
08.05.91 Bulletin 91/19

(84) Designated Contracting States:
**BE DE FR GB NL**

(71) Applicant: **MINNESOTA MINING AND MANUFACTURING COMPANY**
3M Center, P.O. Box 33427
St. Paul, Minnesota 55133-3427(US)

(72) Inventor: **Webb, Richard J. c/o Minnesota Mining & Man.Co**
**2501 Hudson Road**
**St. Paul, Minnesota 55144-1000(US)**
Inventor: **Hoopman, Timothy L. c/o Minnesota Mining &**
**Manufacturing Co, 2501 Hudson Road**
**St. Paul, Minnesota 55144-1000(US)**

(74) Representative: **Baillie, Iain Cameron et al**
c/o Ladas & Parry Isartorplatz 5
W-8000 München 2(DE)

(54) **Planarizing surfaces of interconnect substrates by diamond turning.**

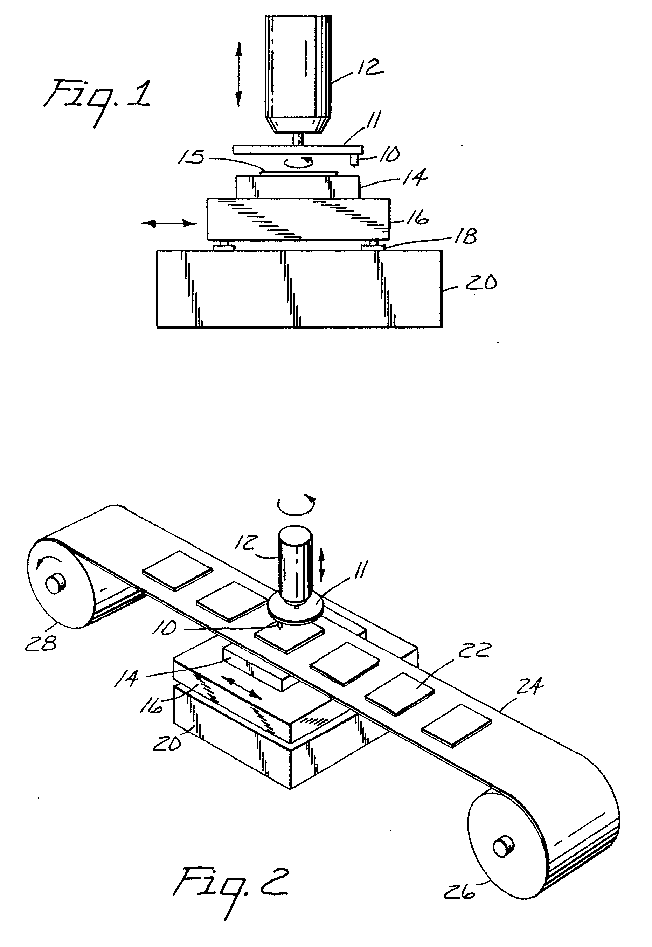

(57) Each of the individual metal-polymer composite layers of an electronic interconnect such as a multi-chip substrate (MCS) can be made to have uniform thickness by diamond turning both the surface of a body on which the MCS is to be built and then successively diamond turning the face of each metal-polymer composite layer that is built on that body. Apparatus useful in large-scale production of MCSs, as illustrated in Fig. 2, includes a long flexible carrier that can travel in short steps to successively position a series of metal-polymer composites to be diamond turned.

Fig. 2

EP 0 426 496 A2

# PLANARIZING SURFACES OF INTERCONNECT SUBSTRATES BY DIAMOND TURNING

## Background of the Invention

### Field of the Invention

The invention is concerned with the production of micro-electronic circuitry and is particularly concerned with a method of planarizing surfaces of an electronic interconnect substrate such as a multi-chip substrate so that each of its layers is of uniform thickness.

### Description of the Related Art

The desirability of multi-layer sandwiches of microelectronic circuitry was recognized prior to the filing in 1963 of the application that issued as U.S. Patent No. 3,314,869 (Dobbin et al). The Dobbin patent says that the prior problem of insulation breakdown between adjacent layers could be avoided by a special electropolishing procedure.

U.S. Patent No.s 3,649,274 (Older et al), 3,791,858 (McPherson et al), and 4,159,222 (Lebow et al) are also concerned with multi-layer printed circuit panels using additive techniques for forming the conductors within each layer. Then after a dielectric has been applied to cover the conductive elements and cured in an oven, the McPherson patent says: "Circuit lines and pins are exposed at the top by removing the excess dielectric. Removal can be accomplished by abrading such as sanding and polishing or by shearing such as microtoming. The methods should be effective to clean the metal surfaces sufficiently to permit good contact with the next applied metal layer...Glass covering the circuit elements is removed by abrading or lapping" (col. 4, lines 35-44).

Older employs precision grinding techniques to make the conductive circuitry "flush" with the remaining photopolymer layer. In Lebow: "The top surface of the insulator material is removed by sanding or otherwise to form a smooth surface coplanar with the tops of the raised interconnects" (col. 2, lines 16-19), thus making that surface suitable for application of the next layer.

U.S. Paten No. 4,681,795 (Tuckerman) concerns the need "to produce a sufficiently flat topography in fabricating a multilevel structure" (col. 1, lines 19-20) and says: "Traditional approaches have involved planarization of the interlevel insulation (dielectric) layers, either by spin-on application (e.g., polyimide), or by reflow (e.g., phosphosilicate glass)" (col. 1, lines 26-29). In Tuckerman's invention, each "metal level is planarized by melting the metal using a pulsed laser prior to patterning" (col. 2, lines 18-20).

In U.S. Patent No. 4,702,792 (Chow et al), microelectronics can be made using a polymeric material that is applied to a substrate and then patterned to form openings. Conductive material is applied to fill the openings, and excess conductive material is removed by chemical-mechanical polishing to expose at least the exterior major surface of the polymeric material. The structure remaining is said to have a planar exterior surface, with conductive features such as fine lines, patterns, and connectors standing alone on the substrate surface.

U.S. Patent No. 4,770,897 (Wu) says: " One of the most versatile and cost effective of the interconnection technologies is a sequentially built multilayer structure of metal conductor and dielectric material using a substrate such as silicon, ceramic or molybdenum.

However, on the of the problems is caused by the protrusion of the metallization pattern that results in an increase in the degree of unevenness as a number of metallization layers increases" (col. 1, lines 26-38). Wu's answer to this problem is a series of steps employing vacuum deposition, photoresist, and electroless plating.

### Related Art That Is Not Prior Art

Pan et al: "A Planar Approach to High Density Copper-polyimide Interconnect Fabrication," Proceedings of the Technical Conference, Eighth Annual International Electronics Packaging Society Conference, Nov. 7-10, 1988, says that modern VLSI devices have created a need for an improved interconnect to take advantage of their high speeds. Pan answers this need with a high density electronic interconnect substrate that is made as follows: "In the MCC interconnect fabrication approach, we use pattern electroplating to plate copper to form the conductor layers and the pillar layers. These copper features are overcoated with nickel for enhanced reliability before polyimide is spin coated over the plated features to partially planarize the topography. Mechanical polishing is then carried out to fully planarize the substrate surface and expose the copper pillars. The substrate is then ready for the next layers of conductor and pillar fabrication", (Abstract, p.174).

Pan's interconnect substrate typically has four layers of interconnect consisting of one power, one ground, and two signal layers. At the surface of each of those four layers are vias which Pan says can be stair-stepped but preferably are pillars that provide shorter paths and hence make higher speeds possible.

After mounting a plurality of chips on his interconnect substrate, Pan obtains a "multi-chip module (MCM)". The interconnect substrate alone is commonly called a "multi-chip substrate" or "MCS".

In an effort to meet the need expressed by Pan, small quantities of MCSs have been available from various sources for several years, but no MCS has been available in production quantities. Information similar to that of the Pan publication is reported in U.S. Patent No. 4,810,332 (Pan).


Summary of the Invention


The present invention provides electronic interconnect substrates, each layer of which is of uniform thickness, thus affording the controlled impedance necessary to their use in MCMs. This is accomplished, using a body that has a machinable surface, by a method comprising the sequential steps of:

a) diamond turning the body at said machinable surface to provide a planar surface,

b) building on said planar surface a metal-polymer composite incorporation microelectronic circuitry, and

c) diamond turning said metal-polymer composite to form a face parallel to said planar surface of the body while leaving vias at said face.

By "diamond turning" is meant rotary machining with a diamond tool, e.g., a lathe, milling machine, or flycutting machine. To achieve the precise cutting that is needed for controlled impedance in MCMs, the diamond turning apparatus should have air bearings. Instead of a diamond tool, one can use any tool of equivalent hardness. Step c) can be followed by the sequential steps of:

d) building on said face a second metal-polymer composite incorporating microelectronic circuitry that is interconnected to vias at said face, and

e) diamond turning said second metal-polymer composite to form a second face that also is parallel to said planar surface of the body while leaving vias at said second face. Steps d) and e) can be sequentially repeated until an MCS is produced having the desired number of interconnected microelectronic circuits.

When said body comprises a mount such as a vacuum chuck, step b) is preceded by the step of mounting on said planar surface a thin durable base such as a nonferrous metal, and a metal-polymer composite is built in step b) on the base. Before the building step, b), the base can be diamond turned to make its surface parallel to the surface of the mount, but this step would be unnecessary when the faces of the base are already parallel to each other. Because the surfaces of the base are parallel, the base can be removed from the mount from time-to time in the course of steps b) and d) in order to apply materials needed to build each metal-polymer composite. The base is then returned to the mount for diamond turning each time it is necessary to afford uniform thickness to the composite or a layer of the composite.

Other useful bases comprise a polymer such as a polyimide, polyester or poly(tetrafluoroethylene) or a durable substance e.g., a ceramic such as alumina, silica, or titania; a silicon wafer; or a ferrous metal such as stainless steel. To provide machinability, the base can be a laminate of a polymer or a nonferrous metal with one of said durable substances. Except as indicated, each of the metal-polymer composites that are built in steps b) and d) can be identical in construction to those employed in the above-cited Tuckerman, Chow, and Wu patents, as well as the Pan article, and the vias can be stair-stepped but preferably are pillars, thus keeping the paths between interconnected microchips as short as possible. Also like Pan, a preferred MCS can be produced by the above-outlined 5-step method, building on said body a sequence of metal-polymer composites to provide ground, X-signal, Y-signal, and power layers.

In practicing the above-outlined method, a control of the thickness of each layer of the MCS within ± 1 $\mu$m has been consistently achieved with a single pass of a diamond tool and ± 0.1 $\mu$m is achievable.

Impedance calculations show that ± 1 μm control is adequate for envisioned MCM requirements.

Polymers useful in building the metal-polymer composites include, but are not limited to polyimides, acrylates, epoxies, polyesters, polysulfones, and bismaleimides. The metal of the metal-polymer composite should be non-ferrous, because ferrous metals tend to cause undue wear of the diamond tool. Preferred are copper, aluminum, gold, silver. Suitable processes for depositing the metal include electroplating, electroless plating, vacuum vapor deposition, and vacuum sputtering. The metal can be patterned using photolithographic, etching, and plating processes well known t those skilled in the microelectronic art.

Diamond tools suitable for practicing the invention preferably have a radius of 0.5 to 5 mm. A tool of smaller radius would provide excellent results but might require frequent resharpening. A tool with a radius above that range might be more sensitive to machine vibration and would provide poorer access to remove debris. A type of tool that has been used with good results is often used to turn the aluminum substrates of magnetic disks and has a leading radius and a flat bottom. Such a diamond tool has provided metal-polymer surfaces with an average roughness (Ra) of about 0.025 μm.

The diamond turning can be carried out with any of a variety of lathe, milling machine, and flycutting machine configurations. The workpieces (including the polymer-metal composites) can be mounted either vertically or horizontally. The diamond tool can rotate while the workpiece is stationary. The workpiece can rotate while the tool is stationary. Both the workpiece and the tool can rotate at various speeds. Optimum rotation rates and tool feed rates depend on such factors as: tool geometry, degree of throughput desired, level of total indicated runout (TIR) control desired, type of materials comprising the composite, and machine design variables. The lowest TIR values are achieved using stiff air bearings for the spindles and tool/chuck carriages.

## Brief Description of the Drawing

In the drawing:

Figure 1 shows a schematic plan view of a precision flycutting machine that is useful or diamond turning in practicing the invention; and

Figure 2 shows a schematic perspective view of apparatus useful for diamond turning the faces of a series os metal-polymer composites in a step-and-repeat process wherein a plurality of polymer-metal composites are sequentially planarized.

## Detailed Description

In Fig. 1, a diamond tool 10 is mounted on a tool holder 11 on an air-bearing spindle 12 that can be moved vertically with respect to a vacuum chuck 14 on which is a base 15 for a metal-polymer composite. The vacuum chuck is mounted on a horizontal table 16 that can be advanced horizontally by air bearing slides 18 on a flat plate 20. Each of the horizontal table and plate can be granite.

The apparatus of Fig. 1., can be modified as shown in Fig. 2 to permit economical large-scale production. To do so, a series of metal-polymer composites 22 are built on a long flexible carrier 24, such as a sheet of stainless steel, that can travel from a feed roll 26 to a take-up roll 28.

The apparatus of Fig. 2 can be used to perform the following sequential steps:

a) diamond turning the vacuum chuck 14 to provide a planar surface,

b) advancing the long flexible carrier 24 until a metal-polymer composite 22 is centered over the planar surface of the vacuum chuck when the chuck is at its initial position to one side of the cutting path of the diamond tool 10,

c) securing the portion of the carrier underlying said composite to the diamond-turned surface of the vacuum chuck by suction,

d) diamond turning the surface of the composite while advancing the vacuum chuck from its initial position toward the side of the diamond tool opposite to said one side,

e) breaking the vacuum to release the carrier,

f) retracting the vacuum chuck to its initial position and, if necessary, adjusting the position of the carrier until the next composite is centered over the planar surface of the vacuum chuck, and

g) sequentially repeating steps (d) through (f) until all of the composites 22 have been diamond turned and wound up with the carrier 24 onto the take-up roll 28.

The carrier 24 and its diamond-turned composites can then be moved to equipment (not shown) at which a second metal-polymer composite is built on each diamond-turned face, after which the carrier can be returned to the apparatus of Fig. 2 to diamond-turn the surfaces of each of those second composites. After thus building and diamond-turning the desired number of metal-polymer composites, the carrier can be cut at the margins of the composites to provide a large number of individual interconnect substrates such as MCSs.

## Test Methods

### Ra and TIR

The average surface roughness (Ra) and total indicated runout (TIR) can be measured by ANSI standard B46.1-1985 on a Tencor Instruments "Alpha-step" 200 profilometer. This instrument is a stylus profilometer which operates by pulling a stylus horizontally across the surface of the sample and measuring its vertical displacement as a function of position. The profilometer is equipped with a 5 $\mu$m radius tip (except where indicated). Scans are 400 $\mu$m in length with a 400 $\mu$m cutoff. Total indicated runout (TIR) is the maximum peak to valley vertical distance within the scan. Average surface roughness (Ra) is calculated from the scan by the instrument. The reported numbers are averages of five scans per sample. Standard deviation tends to be about 50 percent for rough samples and less for smoother samples. All scans are taken perpendicular to the lay of the cut.

### Visual Inspection Value

Visual inspection is performed using an Olympus model BH-2 optical microscope. The samples are examined at 500x under bright field illumination to determine if any polymer has been smeared onto the surface of the metal features as the diamond tool crossed the polymer-metal interface. The amount of smearing is rated as follows:

1 = no visible smearing
2 = some smearing, but covering less than 10% of the surface of a 20 $\mu$m diameter feature
3 = smearing covering greater than 10% of a 20 $\mu$m diameter feature.

### Example 1

Onto a silicon wafer, 0.76 mm thick and 100 mm in diameter, various copper features, such as 25 $\mu$m wide lines and mesh patterns, were electroplated to a thickness of approximately 25 $\mu$m. This structure was overcoated with a polyimide solution (duPont RC5019 polyimide) and cured to provide a final polymer thickness of approximately 50 $\mu$m. The resulting metal-polymer composite was adhered to a 3 mm thick, 11.5 cm diameter acrylic disc which was in turn adhered to a face-plate in the head stock of a precision lathe, both steps being accomplished with double coated pressure-sensitive adhesive tape. The purpose of the acrylic disc was to prevent breaking the brittle silicon wafer when peeling it off the face-plate after machining. A single-crystal diamond radius tool (0.79 mm radius) was mounted in the tool holder on the lathe cross-feed. The face plate was rotated at 500 rpm and the tool was moved slowly toward the sample until, using a magnifier, chips were first observed on the tool. At this point, the tool was advanced across the face of the sample at a rate of 15 $\mu$m/revolution during the first pass and at a rate of 12 $\mu$m/revolution during two subsequent passes. The face of the metal-polymer composite had a visual inspection value of 1 (except examined at 400 X).

### Example 2

Example 1 was repeated except replacing the tool with a tool having a radius of 2.21 mm.

### Example 3

Example 1 was repeated except replacing the polyimide with fluorene epoxy resin. Testing of Examples 1, 2, and 3 is reported in Table I.

| Example No. | Tool Radius (mm) | rpm | Polymer | Ra ($\mu$m) | TIR ($\mu$m) | Visual Inspection Value |
|---|---|---|---|---|---|---|
| 1 | 0.79 | 500 | RC5019 | 0.21 | 1.14 | 1 |
| 2 | 2.21 | 500 | RC5019 | 0.09 | 0.41 | 2 |
| 3 | 0.79 | 500 | Epoxy | 0.09 | 0.64 | 1 |

### Examples 4-14

The configuration of the precision lathe of Examples 1-3 was changed to simulate a flycutting mode of machining. A diamond tool was mounted in a holder on the lathe spindle which rotated the tool at 700 rpm in a circle approximately 15 cm in diameter. A vacuum chuck was affixed to the cross-feed to hold the sample perpendicular to the spindle. To machine a sample, the longitudinal feed was used to set the depth of cut, and the cross-feed moved the sample past the cutter producing the planarized surface. Some samples were machined in this mode with a single-crystal tool, others were done with a polycrystalline tool. Test data is reported in Table II.

6

Table II

| Example No. | Tool Radius* (mm) | Polymer** | Ra (μm) | TIR (μm) | Visual Inspection Value |
|---|---|---|---|---|---|
| 4 | 3.12 | BMI(CG) | 0.35 | 1.48 | 2 |
| 5 | 3.12 | PES(V) | 0.14 | 0.66 | 1 |
| 6 | 3.18MD | LP84 | 0.28 | 1.46 | 3 |
| 7 | 3.18MD | PO84 | 0.30 | 1.82 | 3 |
| 8 | 3.12 | LP84 | 0.08 | 0.38 | 2 |
| 9 | 3.12 | LP84 | 0.06 | 0.43 | 1 |
| 10 | 3.12 | XHTA | 0.06 | 0.31 | |
| 11 | 3.12 | Ultem | 0.04 | 0.24 | 1 |
| 12 | 3.12 | XHTA | 0.14 | 0.85 | 1, 2 |
| 13 | 3.18MD | LP84 | 0.26 | 1.40 | 2 |
| 14 | 3.12 | XHTA | 0.07 | 0.37 | 1 |

* Single crystal tool except: MD = "Megadiamond" polycrystalline diamond tool
** BMI(CG) = Bismaleimide (Ciba-Geigy "Matrimide" 5292)
PES(V) = Polyethersulfone resin ("Victrex PES4800P" International Chemical Industries Inc.)
LP84 = Pre-imidized polyimide ("Lenzing" P84)
XHTA = Acrylic (Rhom-Haas XHTA245)
Ultem = Pre-imidized polyetherimide (General Electric "Ultem" 1000)

Example 15

A diamond tool (Philips model 7222 474 11220) with a 6 mm radius was mounted in a flycutter like that illustrated in the drawing and comprised of: a Model 3950 positioning system from Anorad Corp. (Hauppauge, NY); a Model 4R air-bearing spindle from Professional Instruments, Inc. (Minneapolis, MN); and a Professional Instruments designed tool holder. This flycutter had a position resolution on the vertical axis of 0.25 μm, and the orthogonality of the axes of the machine was better than ± 2 arc-seconds.

An aluminum vacuum chuck was mounted on the horizontal table of the flycutter and trued by cutting with a diamond tool of radius 0.8 mm, providing a surface precisely parallel to the travel of the table. The spindle was turned on and allowed to warm up for approximately one hour at 3000 rpm to allow it to come to thermal equilibrium. (The warm-up could have been avoided by using a more sophisticated and expensive spindle with active temperature control.) The vertical position was then calibrated by cutting and measuring a piece of acrylic. A metal-polymer composite like that used in Example 1 was secured to the chuck, and the vertical axis was positioned to provide the desired thickness. While rotating the spindle at 5000 rpm, the table, including the chuck and part, was then passed under the cutter at a speed of 10.0 cm/min. to form a face parallel to the planar surface of the chuck while leaving vias at said face.

Examples 16-22

A series of metal-polymer composites were diamond turned in the same way as in Example 15 except

7

as indicated in Table III and that the feed rate for Examples 16-20 was 1.25 cm/min. and for Examples 21 and 22 was 15 cm/min. Table III also reports testing of Examples 15-22.

Table III

| Example No. | RPM | Polymer* | Metal | Ra (μm) | TIR (μm) | Visual Inspection Value |
|---|---|---|---|---|---|---|
| 15 | 5000 | LP84 | Cu | 0.14 | 0.73 | 1 |
| 16 | 5000 | LP84 | Cu | 0.09 | 0.74 | 2 |
| 17 | 5000 | LP84 | Cu | 0.04 | 0.24 | 3 |
| 18 | 5000 | C896 | Cu | 0.06 | 0.36 | 1, 2 |
| 19 | 500 | LP84 | Cu | 0.15 | 0.73 | 1 |
| 20 | 5000 | LP84 | Al | 0.11 | 0.70 | 1, 2 |
| 21 | 5000 | C896 | Cu | 0.09 | 0.68 | 1 |
| 22 | 5000 | C896 | Cu | 0.10 | 00.63 | 1, 2 |

* LP84 = Pre-imidized polyimide ("Lenzing" P84)
C896 = Toughened bismaleimide ("Compimide" 896 from Boots-Technochemie)

The flycutter used in Example 15 has been employed for diamond turning metal-polymer composites to produce satisfactory surfaces at feed rates from 0.63 to 70.0 cm/min., spindle speeds from 500 to 5000 rpm, and diamond tool radii from 0.7 to 6.0 mm (with a tool holder radius of 112 mm). These parameters should be chosen to afford the desired TIR. For example, to obtain a given TIR with a tool of smaller radius, the feed rate must be reduced or the spindle speed increased. Best results have been attained at a feed rate from 7 to 20 cm/min., a spindle speed of 2000 to 4000 rpm, and a diamond tool radius of 0.8 mm.

**Claims**

1. Method of producing an electronic interconnect substrate using a body that has a machinable surface, said method comprising the sequential steps of:
   a) diamond turning the body at said machinable surface to provide a planar surface,
   b) building on said planar surface a metal-polymer composite incorporating microelectronic circuitry, and
   c) diamond turning said metal-polymer composite to form a face parallel to said planar surface of the body while leaving vias at said face.
2. Method as defined in claim 1 wherein the vias are pillars.
3. Method as defined in Claim 1 wherein step c) is followed by the sequential steps of:
   d) building on said face a second metal-polymer composite incorporating microelectronic circuitry that is interconnected to vias at said face, and
   e) diamond turning said second metal polymer composite to form a second face that also is parallel to said planar surface of the body while leaving vias at said second face.
4. Method as defined in claim 3 wherein steps d) and e) are sequentially repeated until a multi-chip substrate is produced that has the desired number of interconnected microelectronic circuits.
5. Method as defined in claim 4 wherein step b) provides a first metal-polymer composite that serves as a ground layer and steps d) and e) are sequentially repeated to provide second, third, and fourth metal-polymer composites that provide X-signal, Y-signal, and power layers.
6. Method as defined in claim 1 wherein said body comprises a base.
7. Method as defined in claim 6 wherein said machinable surface of said base is provided by a material selected from a polymer and a nonferrous metal.
8. Method as defined in claim 7 wherein said base comprises a laminate of said material and a durable substance selected from ceramic, silicon, and ferrous metal.

9. Method as defined in claim 8 wherein said laminate comprises a ceramic wafer bearing a layer of a machinable polymer.

10. Method as defined in claim 9 wherein said machinable polymer is a polyimide.

11. Method as defined in claim 1 wherein said body comprises a mount, and prior to step a) is the step of diamond turning a surface of the mount.

12. Method as defined in claim 11 wherein the metal-polymer composite is built in step b) to be removable from the mount.

13. Method as defined in claim 1 wherein subsequent to the step of diamond turning a surface of the mount and prior to step b) is the step of mounting on the mount a base for the metal-polymer composite to be built in step b), which base has flat surfaces parallel to each other.

14. Method as defined in claim 1 wherein said base comprises a durable substance selected from ceramic, silicon, and ferrous metal.

15. Method of producing a plurality of electronic interconnect substrates using a step-and-repeat process, said method comprising the steps of:

a) diamond turning a chuck to provide a planar surface,

b) building a series of metal-polymer composites on a long flexible carrier,

c) advancing the carrier until one of said composites is centered over the planar surface of the chuck,

d) Securing to the diamond-turned surface of the chuck the portion of the carrier underlying said one composite,

e) diamond turning the surface of said one composite while advancing the chuck,

f) releasing the carrier from the chuck,

g) retracting the chuck,

h) securing the portion of the carrier underlying the next composite to the diamond-turned surface of the chuck, and

i) repeating steps e) through h) until all of the secured composites have been diamond turned.

16. Method as defined in claim 15 wherein each of steps d) and h) comprises securing the carrier to the chuck by applying a vacuum to the chuck.

17. An electronic interconnect substrate comprising a plurality of layers of metal-polymer composite incorporating microelectronic circuitry, layers of which have been diamond turned by the method of claim 1 to afford uniform thicknesses.

18. Apparatus for planarizing surfaces of each of a series of electronic interconnect substrates, each of which has a composite metal-polymer face, said apparatus comprising

a) a diamond turning tool,

b) a body having a machinable surface,

c) means for diamond turning the body with said tool to give said machinable surface a planar surface,

d) a flexible carrier,

e) means for securing a series of interconnect substrates to one face of the carrier,

f) means for stepwise advancing said carrier to position each of said interconnect substrates sequentially over said body, and

g) means for temporarily securing to said body the portion of the carrier underlying the positioned composite to permit diamond turning of the exposed face of said composite.

19. Apparatus as defined in claim 18 wherein said body comprises a vacuum chuck.

Fig. 1

Fig. 2